# EUROPEAN PATENT SPECIFICATION

(11) **EP 2 157 700 B1**
(45) Date of publication and mention of the grant of the patent: **17.08.2011**
(21) Application number: 08014697.0
(22) Date of filing: 19.08.2008
(51) Int. Cl.: H03M 3/00

(54) **Delta-sigma analog-to-digital converter circuit and method for analog-to-digital converting**
Delta-Sigma-Analog-Digital-Wandlerschaltung und Verfahren zur Analog-Digital-Umwandlung
Circuit de convertisseur analogique-numérique delta-sigma et procédé de conversion analogique-numérique

(43) Date of publication of application: 24.02.2010
(73) Proprietor: Trident Microsystems (Far East) Ltd., Grand Cayman (KY)
(72) Inventor: Noeske, Carsten, 79350 Sexau (DE)
(74) Representative: Epping - Hermann - Fischer

(56) References cited:
- US-A- 6 147 634
- US-A1- 2007 279 268

## Description

### Technical Field

The invention relates to a Delta-Sigma Analog-to-Digital Converter circuit according to pre-characterizing part of claim 1, and to a method for analog-to-digital converting.

### Background Art

Circuits and methods to be used in the conversion of an analog signal to the digital domain, which are based on a delta-sigma modulation technique, are well known.

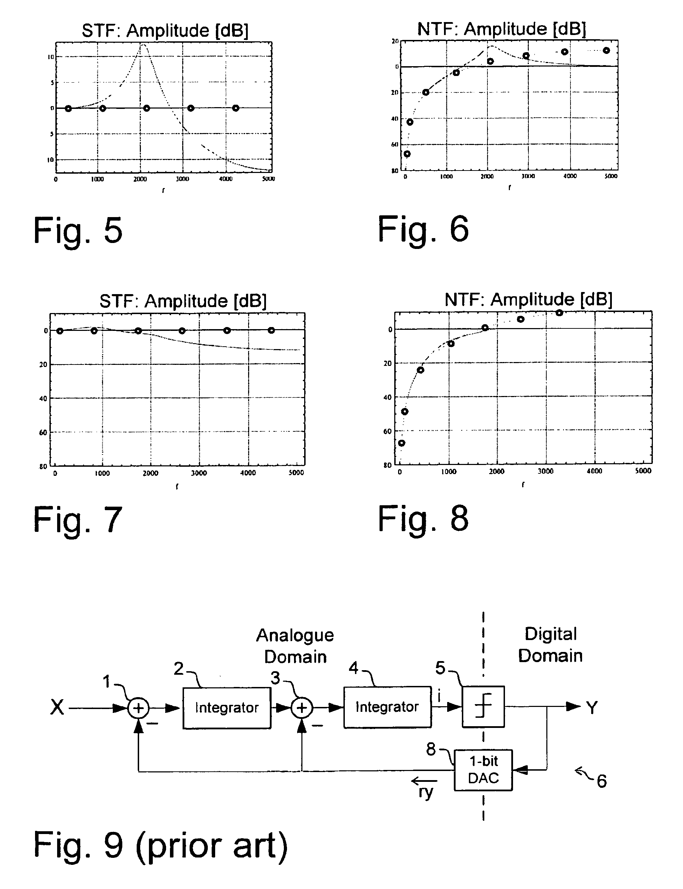

Figure 9 shows a prior art 2^{nd} order 1-bit Delta-Sigma Analog-to-Digital Converter. An analog input signal X is inputted to a first adder 1 being designed to subtract a value from the input signal X. An output value or signal of the adder 1 is inputted into a first integrator 2. An integrated output signal of the first integrator 2 is inputted into a second adder 3. The second adder 3 is designed to subtract the value to be subtracted from input signal X in first adder 1. The output of the second adder 3 is inputted into a second integrator 4. The integrated signal i is outputted of the second integrator 4 to a quantizer 5. These components are components being designed to handle analog signals or analog values.

The quantizer 5 is designed to output a converted digital signal Y. The converted signal Y is outputted to other components to be processed therein. In addition, the converted signal Y is applied to a 1-bit Digital-to-Analog-Converter 8. The Digital-to-Analog-Converter 8 converts the applied converted signal respectively value to a reconverted analog signal ry. The reconverted signal ry is applied to the first and second adder 1, 3 to be subtracted from the other corresponding input signal of the adders 1, 3. Thus, the converted signal Y is fed back via a feedback path 6 to be subtracted within the adders 1, 3.

Such a delta-sigma based Analog-to-Digital Converter utilizes a high oversampling ratio (OSR) to have the possibility to shape an error signal introduced by the quantization spectrally, so that the Signal-to-Noise Ratio (SNR) in the passband is maintained. Due to the shaping the bit resolution of the quantizer 5 can be very low, e.g. 1-bit.

The shaping is achieved by feeding the quantized signal back from the digital domain to the analog one via the feedback path 6 and by deriving the error between the input signal X and the converted signal Y. The differential signal is integrated again in the analog domain, which leads to a signal, that consists of the input signal X plus an integrated and inverted error signal. By feeding this signal i including this error signal back again, the error is cancelled in the integrator for low frequency components, which means the quantization error is shaped.

Alternatively other modulator structures are known such as modulators of higher-order or feed-forward structures . Since this application deals with an improvement in the digital feedback path, the following elucidations are valid also for such architectures.

US patent 6,147,634, assigned to Rangan et al, and US patent application 2007/279268, assigned to Chen et al, describe delta -sigma analogue -to -digital converters comprising a quantizer for outputting a digital converted signal and a feedback path with a digital-to-analogue converter for processing the converted signal and for feeding back the processed analogue signal, in which the feedback path comprises a digital filter arranged before the digital-to-analogue converter, the digital filter being arranged and/or controlled for digital filtering the converted signal. In US 6,147,634 the digital filter is tuned to attenuate components of the digital signal having frequencies near one-half the sampling rate frequency and to pass other components of the digital signal having frequencies away from one-half the sampling rate frequency. In US 2007/279268 the digital filter is used to counteract the function of an analogue filter arranged after the digital-to-analogue converter which is used to shape the noise of the digital-to-analogue converter out of the signal band.

### Technical Problem

For high-bandwidth applications such as the conversion of video signals, the usage of delta-sigma ADCs lead for prior art architectures to the following implementation decisions: Either the sampling-rate has to be very high, e.g. in the range of some GHz, or the delta-sigma order has to be increased, which leads to stability issues and increases the cost and efforts in the analog part, or the quantizer and the feedback-DAC has to be implemented as multi-bit. The higher the sampling frequency, the more the influence of jitter becomes a degrading factor. Especially the negative influence on the feedback DAC deteriorates the overall performance, since its errors are not shaped by the converter topology such as the ones of the quantizer. Since the jitter sensitivity depends on the ratio between average jitter and clock cycle duration, the reduction of the sampling frequency becomes more and more attractive, but to maintain the SNR the price are multi-bit quantizers and feedback converters, as outlined before. These have issues with linearity, so that the gain in less jitter sensitivity due to the lower clock rate has its price.

It is an object of the invention to provide an alternative Delta-Sigma Analog-to-Digital Converter circuit having simple construction and method for analog-to-digital converting making possible the use in high-bandwidth applications.

### Technical Solution

This object is solved by a Delta-Sigma Analog-to-Digital Converter circuit having features according to claim 1, and by a method for analog-to-digital convertion having features according to claim 7. Preferred aspects and embodiments are subject-matter of dependent claims.

Especially, there is provided a Delta-Sigma Analog-to-Digital Converter circuit comprising a quantizer arranged and/or controlled for outputting a digital converted signal and a feedback path with a Digital-to-Analog Converter arranged and/or controlled for processing the converted signal and for feeding back the processed analog signal, wherein the feedback path comprises a digital filter arranged before the Digital-to-Analog Converter, the digital filter being arranged and/or controlled for digital filtering the converted signal. Especially, the digital filter is a decimation filter. The underlying idea is, that the spectrum of the feedback signal has to match that of the quantizer input signal only in the passband exactly. By taking provision, that the passband spectrum is not affected, the feedback DAC could run on a lower rate, which gives a vast benefit concerning jitter sensitivity and power consumption.

According to another embodiment a Pulse-Width-Modulation modulator is arranged between the digital filter and the Digital-to-Analog Converter.

Especially, a digital higher-order Delta-Sigma Modulator or Noise Shaper is arranged between the digital filter and the Digital-to-Analog Converter in the feedback path, the Digital-to-Analog Converter being a n-bit Digital-to-Analog Converter, and a further digital higher-order Delta-Sigma Modulator or Noise Shaper is arranged between a further digital filter and a further Digital-to-Analog Converter in a further feedback path, the Digital-to-Analog Converter being a m-bit Digital-to-Analog Converter. These components in the first feedback path are arranged and/or controlled for feeding back their processed analog signal to a second of the adders, the second of the adders being arranged between the integrators and being arranged and/or programmed for calculating a difference of an integrated signal and the applied processed analog signal, and these components in the further feedback path are arranged and/or controlled for feeding back their processed analog signal to a first of the adders, the first of the adders being arranged and/or programmed for calculating a difference of the input signal and the applied processed analog signal. According to a further embodiment a digital higher-order Delta-Sigma Modulator or Noise Shaper is arranged between the digital filter and the Digital-to-Analog Converter.

A preferred circuit comprises in the feedback path a device being arranged and/or programmed for decreasing a sampling rate of the converted signal, the Digital-to-Analog Converter being arranged and/or programmed as a 1-bit Digital-to-Analog Converter.

Further, there is provided a method for analog-to-digital converting, wherein an analog input signal is processed and quantizised to a digital converted signal, and the converted signal is processed for feeding back a reconverted analog signal to be used for calculation of a difference signal, wherein the converted signal is digitally filtered before reconverting it to analog domain.

Especially, a decimation filter is used for the digital filtering. The digital filtered signal can be processed by a Pulse-Width-Modulation. Further, the digital filtered signal can be processed by a digital higher-order Delta-Sigma modulation or noise shaping. The converted signal can be resampled for decreasing its sampling rate, and to convert it in a 1-bit Digital-to-Analog Converter to get the reconverted analog signal.

### Advantageous Effects

While the quantizer remains very simple, e.g. a 1-bit decider, and can easily be implemented on high sampling rates, the implementation of a feedback DAC at very high clock speeds is a problem. All errors it introduces are not shaped and are visible in the output signal of the analog-to-digital converter. Especially the jitter sensitivity depends on the ratio between average jitter and clock cycle duration, and this becomes worse the higher the clock speed is. With the digital reduction of the sampling rate in the feedback path, the DAC can run on a lower sampling rate avoiding the previous mentioned problems. In order to reduce the number of bits for the DAC, the digital delta-sigma modulator or noise shaper can be used after the decimation. In order to maintain the passband Signal-to-Noise ratio (SNR), the order of this quantization error shaping circuit has to be higher than the one of the whole Delta-Sigma Analog-to-Digital Converter itself, which is no problem in the digital domain.

Thus, there is provided a high-bandwidth Delta-Sigma Analog-to-Digital Converter architecture.

### Description of Drawings

An embodiment will be disclosed in more details with respect to enclosed drawing. A first circuit is described in detail. Further circuits are described only with respect to differences over the first circuit. With respect to other components and functions description of first circuit shall be taken. There are shown in:
- Fig. 1: a circuit showing a main aspect of a preferred 2^{nd} order Delta-Sigma Analog-to-Digital Converter with a digital filter in a feedback path,
- Fig. 2: another a circuit showing a 2^{nd} order 1-bit Delta- Sigma Analog-to-Digital Converter with a decimation filter in the feedback path,
- Fig. 3: another a circuit showing a 2^{nd} order Delta-Sigma Analog-to-Digital Converter with additionally a pulse width modulation modulator in the feedback path,
- Fig. 4: an alternative 2^{nd} order Delta-Sigma Analog-to- Digital Converter with separate feedback pathes,
- Fig. 5, 6: filter functions to highlight effects of preferred circuit over a prior art circuit,
- Fig. 7 and 8: ffunctions of an example with a 8-tab FIR- Filter.
- Fig. 9: a circuit according to the prior art.

### Mode for Invention

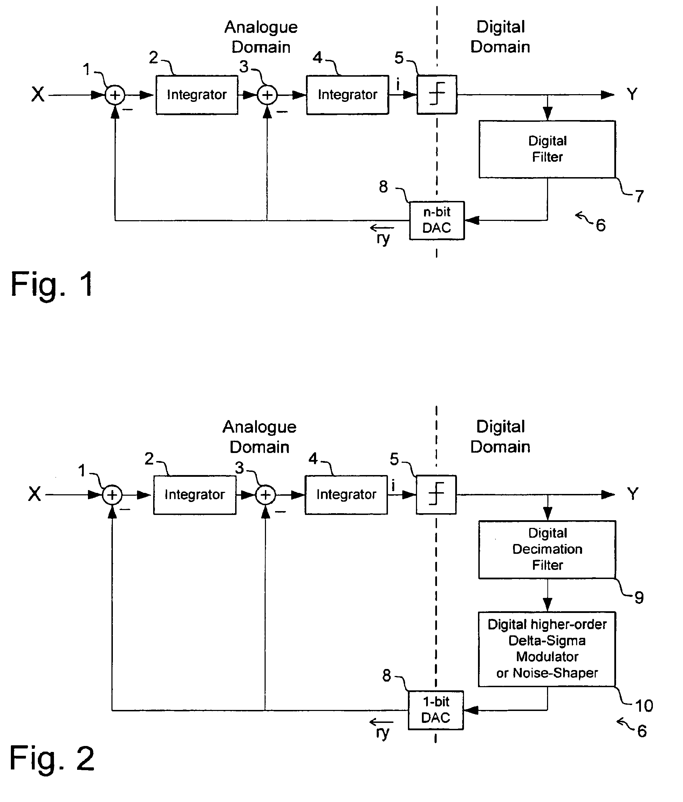

Fig. 1 shows a first preferred 2^{nd} order Delta-Sigma Analog-to-Digital Converter. An analog input signal X is inputted to a first adder 1 being designed to subtract a value from the input signal X. Output values respectively a output signal of the first adder 1 is inputted into a first integrator 2. Integrated output signal of the integrator 2 is inputted into a second adder 3. The second adder 3 is designed to subtract the value to be subtracted from input signal X in first adder 1. The output of the second adder 3 is inputted into a second integrator 4. An integrated signal i is outputted out of the second integrator 4 into a quantizer 5. These components are components being designed to handle analog signals respectively analog values.

The quantizer 5 is designed to output a converted signal Y being a digital signal. The converted signal Y is outputted to other components to be processed further. In addition, the converted signal Y is applied to a digital filter 7. A filtered signal filtered by the digital filter 7 is applied to a n-bit Digital-to-Analog-Converter 8. The Digital-to-Analog-Converter 8 converts the applied converted signal respectively value to an reconverted signal ry being an analog signal. The reconverted signal ry is applied to the first and second adder 1, 3 to be subtracted from the corresponding other input signals of the adders 1, 3. Thus, the converted signal Y is feed back via a feedback path 6 to be subtracted within the adders 1, 3.

The invention utilizes the fact, that the non-linear element - the quantizer 5 - can be regarded as being an adder of a noise signal in form of an quantization error signal. In this linear system, the error in the passband is shaped as long as the passband remains untouched by filtering. Therefore also filtering in the digital domain is feasible. Also additional quantizers 5 can be implemented as long as the noise they introduce is outside the passband or much more smaller than the shaped noise of the main quantizer.

Therefore, according to a main aspect a jitter sensitivity of the system is reduced by digital filtering in the feedback path 6. However, a drawback is an increase in bit resolution of the Digital-to-Analog Converter 8.

Optionally the sampling rate for the Digital-to-Analog Converter 8 can be decreased by downsampling after the filtering or inside if e.g. a polyphase filter is used.

Further, using a 2^{nd} order 1-bit Delta-Sigma Analog-to-Digital Converter according to Figure 2, the jitter sensitivity of the system can be reduced. In contrast to the converter according to Fig. 1 the converted signal Y is applied to a digital decimation filter 9. A signal outputted out of the digital decimation filter 9 is applied to a digital higher-order Delta-Sigma modulator or a Noise-Shaper 10. Signal outputted of the digital higher-order Delta-Sigma modulator or of the Noise-Shaper 10 is outputted to a 1-bit Digital-to-Analog Converter 8. The analog reconverted signal ry outputted out of the 1-bit Digital-to-Analog Converter 8 is subtracted in the first and third adder 1, 3.

In this circuit the jitter sensitivity of the system is reduced by reducing the sampling rate for the Digital-to-Analog Converter 8 by down-sampling and reducing the bit resolution of the still over-sampled signal by a higher-order noise shaper or digital delta-sigma modulator 10. Since the order of the digital delta-sigma modulator 10 is significantly higher than the order of the analog one, the Digital-to-Analog Converter 8 can run on a reduced sampling frequency and is therefore less sensitive against jitter.

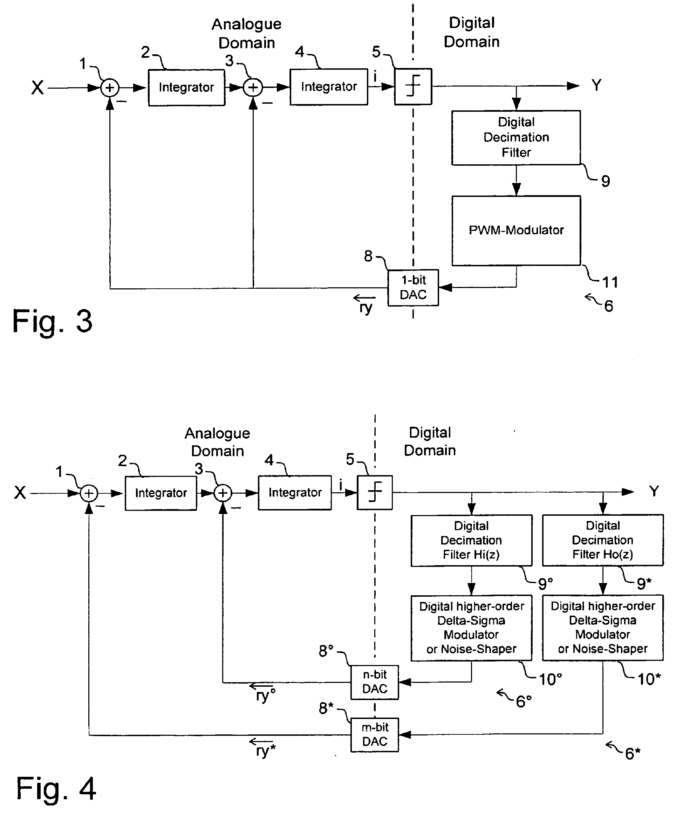

Figure 3 shows an alternative circuit comprising a 2^{nd} order Delta-Sigma Analog-to-Digital Converter with Pulse-Width-Modulation (PWM) modulator 11 in feedback path 6. The signal of a digital decimation filter 9 is applied to the pulse-width-modulation modulator 11. Its output signal is applied to the 1-bit Digital-to-Analog Converter 8 instead of applying the signal of the digital decimation filter 9 to the digital higher-order Delta-Sigma modulator or Noise-Shaper 10.

The use of the Pulse-Width-Modulation modulator 11 in the feedback path is similar to a 1-bit Digital-to-Analog Converter 8 apart from the fact, that it derives the 1-bit signal by a non-linear transform.

In general there are several variations of the topology possible, e.g. several feedback paths 6°, 6* instead of only one feedback path 6. Every feedback path 6°, 6* can be implemented with a separate filter function, different decimation factors etc. Figure 4 shows an alternative 2^{nd} order Delta-Sigma Analog-to-Digital Converter with such separate feedback paths 6°, 6*. In the first of these feedback paths 6° the converted signal Y is applied to a digital decimation filter Hi(z) 9° the output signal of which is applied to a digital higher-order Delta-Sigma modulator or Noise-Shaper 10° and then to a n-bit Digital-to-Analog Converter 8°. A reconverted signal ry° is applied to the second adder 3 to be subtracted from the signal outputted out of the first integrator 2.

Further, the converted signal Y is applied to a further digital decimation filter Ho(z) 9*. The output of this digital decimation Ho(z) 9* is inputted into a further digital higher-order Delta-Sigma modulator or Noise-Shaper 10*, the signal outputted of which is inputted into a further m-bit Digital-to-Analog Converter 8*. A reconverted signal ry* is outputted from this m-bit Digital-to-Analog Converter 8* to be subtracted in the first adder 1 from a next input signal X.

It should also be noted, that the Digital-to-Analog Converters 8 might include a FIR filter built with current sources or switched capacitor elements or an analog filter.

In order to outline the theory behind these circuits a few examples are given how the digital filtering influences the overall transfer function of the input signal X to the output and of the error signal shaping. These functions can be calculated by modeling the integrators 2, 4 in the drawing with digital ones and calculating the transfer functions. In principle, the digital filters introduce additional delays in the feedback path. These increase the so-called "excess loop delay", which describes the delay between sampling point in time in the quantizer and the DAC conversion of this signal. Usually the quantizer samples on the rising edge of the clock, while the DAC outpus new samples with the falling one. Therefore the "excess loop delay" is often half the sampling period. Now the group delays of the filters have to be added. Since these delays influence stability and the transfer functions, sometimes it is useful to take counter measures in the modulator by introducing additional feed-forward paths.

Figures 5 and 6 show an example from figure 9 over circuits according to present circuits with a filter function (1+z⁻¹)/2. Figure 5 shows the signal transfer function STF(z) = Y/X. Figure 6 shows the noise transfer function (NTF), which shapes the quantization error. In both plots the transfer functions according to the prior art are also given with a line marked with small circles.

As can seen by the example, the additional filter function hardly influences the signal and error transfer functions in the passband.

Figures 7 and 8 shows an example with a 8-tap FIR-filter. Figure 7 shows an input signal transfer function (STF) and Figure 8 shows an error shaping (NTF).

## Claims

1. Delta-Sigma Analog-to-Digital Converter circuit comprising
- a quantizer (5) arranged and/or controlled for outputting a digital converted signal (Y),
- a feedback path (6) with a Digital-to-Analog Converter (8) arranged and/or controlled for processing the converted signal (Y) and for feeding back the processed analog signal (ry),
- wherein the feedback path (6; 6°, 6*) comprises a digital filter (7; 9, 10; 9, 11; 9°, 10°, 9*, 10*) arranged before the Digital-to-Analog Converter (8; 8°, 8*), the digital filter (7; 9, 10; 9, 11; 9°, 10°, 9*, 10*) being arranged and/or controlled for digital filtering the converted signal (Y), and **characterised in that**
- the digital filter (9, 10; 9, 11; 9°, 10°, 9*, 10*) is a decimation filter.

2. Circuit according to claim 1, wherein a digital Delta-Sigma Modulator or Noise Shaper (10) is arranged between the digital filter (9) and the Digital-to-Analog Converter (8).

3. Circuit according to claim 1, wherein
- a digital Delta-Sigma Modulator or Noise Shaper (10°) is arranged between the digital filter (9°) and the Digital-to-Analog Converter (8°) in the feedback path (6°), the Digital-to-Analog Converter (8°) being a n-bit Digital-to-Analog Converter, and
- a further digital higher-order Delta-Sigma Modulator or Noise Shaper (10*) is arranged between a further digital filter (9*) and a further Digital-to-Analog Converter (8*) in a further feedback path (6*), the Digital-to-Analog Converter (8*) being a m-bit Digital-to-Analog Converter.

4. Circuit according to claim 3, wherein
- these components in the first feedback path (6°) are arranged and/or controlled for feeding back their processed analog signal (ry°) to a second adder (3), the second adder (3) being arranged between integrators (2, 4) and being arranged and/or programmed for calculating a difference of an integrated signal and the applied processed analog signal (ry°), and
- these components in the further feedback path (6*) are arranged and/or controlled for feeding back their processed analog signal (ry*) to a first adder (3), the first adder (3) being arranged and/or programmed for calculating a difference of the input signal (X) and the applied processed analog signal (ry*).

5. Circuit according to any preceding claim, comprising in the feedback path (6) a device being arranged and/or programmed for decreasing a sampling rate of the converted signal (Y).

6. Circuit according to one of the preceding claims 1 to 5, wherein the Digital-to-Analog Converter (8) is arranged and/or programmed as a 1-bit Digital-to-Analog Converter (8).

7. Method for analog-to-digital converting, wherein
- an analog input signal (X) is processed and quantizised to a digital converted signal (Y),
- the converted signal (Y) is processed for feeding back a reconverted analog signal (ry) to be used for calculation of a difference signal,
- the converted signal (Y) is digitally filtered before reconverting it to the reconverted analog signal (ry), and
**characterised in that**
- a decimation filter is used for the digital filtering.

8. Method according to claim 7, wherein the digital filtered signal is processed by a Pulse-Width-Modulation.

9. Method according to claim 7 or 8, wherein the digital filtered signal is processed by digital Delta-Sigma modulation or noise shaping.

10. Method according to any of claims 7 to 9, wherein the converted signal (Y) is re-sampled for decreasing its sampling rate, and converted in a Digital-to-Analog Converter to get the reconverted analog signal (ry).

## Patentansprüche

1. Delta-Sigma-A/D-Wandlerschaltung, umfassend
- einen Quantisierer (5), der zu dem Zweck eingerichtet ist und/oder gesteuert wird, ein digitales umgewandeltes Signal (Y) auszugeben,
- einen Rückkopplungspfad (6) mit einem D/A-Wandler (8), der zu dem Zweck eingerichtet ist und/oder gesteuert wird, das umgewandelte Signal (Y) zu verarbeiten und das verarbeitete analoge Signal (ry) rückzukoppeln,
- wobei der Rückkopplungspfad (6; 6°; 6*) ein digitales Filter (7; 9, 10; 9, 11; 9°, 10°, 9*, 10*) umfasst, das dem D/A-Wandler (8; 8°; 8*) vorgeschaltet ist, wobei das digitale Filter (7; 9, 10; 9, 11; 9°, 10°, 9*, 10*) zu dem Zweck eingerichtet ist und/oder gesteuert wird, am umgewandelten Signal (Y) eine digitale Filterung auszuführen, und **dadurch gekennzeichnet, dass**
- das digitale Filter (9, 10; 9, 11; 9°, 10°, 9*, 10*) ein Dezimierungsfilter ist.

2. Schaltung nach Anspruch 1, wobei zwischen dem digitalen Filter (9) und dem D/A-Wandler (8) ein digitaler Delta-Sigma-Modulator oder eine digitale Rauschformerschaltung (10) angeordnet ist.

3. Schaltung nach Anspruch 1, wobei
- zwischen dem digitalen Filter (9°) und dem D/A-Wandler (8°) im Rückkopplungspfad (6°) ein digitaler Delta-Sigma-Modulator oder eine digitale Rauschformerschaltung (10°) angeordnet ist, wobei es sich bei dem D/A-Wandler (8°) um einen n-Bit-D/A-Wandler handelt, und
- ein weiterer digitaler Delta-Sigma-Modulator oder eine weitere digitale Rauschformerschaltung (10*) höherer Ordnung zwischen einem weiteren digitalen Filter (9*) und einem weiteren D/A-Wandler (8*) in einem weiteren Rückkopplungspfad (6*) angeordnet ist, wobei der dem D/A-Wandler (8*) ein m-Bit-D/A-Wandler ist.

4. Schaltung nach Anspruch 3, wobei
- diese Komponenten im ersten Rückkopplungspfad (6°) zu dem Zweck eingerichtet sind und/oder gesteuert werden, ihr verarbeitetes analoges Signal (ry°) zu einem zweiten Addierer (3) rückzukoppeln, wobei der zweite Addierer (3) zwischen Integriergliedern (2, 4) angeordnet ist und zu dem Zweck eingerichtet und/oder programmiert ist, eine Differenz zwischen einem integrierten Signal und dem anliegenden verarbeiteten analogen Signal (ry°) zu berechnen, und
- diese Komponenten im weiteren Rückkopplungspfad (6*) zu dem Zweck eingerichtet sind und/oder gesteuert werden, ihr verarbeitetes analoges Signal (ry*) zu einem ersten Addierer (3) rückzukoppeln, wobei der erste Addierer (3) zu dem Zweck eingerichtet und/oder programmiert ist, eine Differenz zwischen dem Eingangssignal (X) und dem anliegenden verarbeiteten analogen Signal (ry*) zu berechnen.

5. Schaltung nach jedem vorhergehenden Anspruch, die im Rückkopplungspfad (6) ein Bauelement aufweist, das zu dem Zweck eingerichtet und/oder programmiert ist, eine Abtastrate des umgewandelten Signals (Y) zu senken.

6. Schaltung nach einem der vorhergehenden Ansprüche 1 bis 5, wobei der D/A-Wandler (8) als 1-Bit-D/A-Wandler (8) eingerichtet und/oder programmiert ist.

7. Verfahren zur A/D-Umwandlung, wobei
- ein analoges Eingangssignal (X) zu einem digitalen umgewandelten Signal (Y) verarbeitet und quantisiert wird,
- das umgewandelte Signal (Y) verarbeitet wird, um ein erneut umgewandeltes analoges Signal (ry) rückzukoppeln, das zur Berechnung eines Differenzsignals zu verwenden ist,
- das umgewandelte Signal (Y) digital gefiltert wird, bevor es wieder zu dem erneut umgewandelten, analogen Signal (ry) umgewandelt wird, und
**dadurch gekennzeichnet, dass**
- für die digitale Filterung ein Dezimierungsfilter verwendet wird.

8. Verfahren nach Anspruch 7, wobei das digitale gefilterte Signal durch eine Pulsbreitenmodulation verarbeitet wird.

9. Verfahren nach Anspruch 7 oder 8, wobei das digitale gefilterte Signal durch eine digitale Delta-Sigma-Modulation oder Rauschformung verarbeitet wird.

10. Verfahren nach einem der Ansprüche 7 bis 9, wobei das umgewandelte Signal (Y) erneut abgetastet wird, um seine Abtastrate zu senken, und in einem D/A-Wandler umgewandelt wird, um zu dem erneut umgewandelten, analogen Signal (ry) zu gelangen.

## Revendications

1. Circuit convertisseur analogique-numérique delta-sigma comportant
- un quantificateur (5) disposé et/ou commandé pour sortir un signal converti en numérique (Y),
- un chemin de retour (6) comportant un convertisseur numérique-analogique (8) disposé et/ou commandé pour traiter le signal converti (Y) et pour retourner le signal analogique traité (dry),
- où le chemin de retour (6 ; 6°, 6*) comporte un filtre numérique (7; 9, 10 ; 9, 11 ; 9°, 10°, 9*, 10*) disposé en amont du convertisseur numérique-analogique (8°, 8*), le filtre numérique (7 ; 9, 10 ; 9, 11 ; 9°, 10°, 9*, 10*) étant disposé et/ou commandé pour filtrer numériquement le signal converti (Y), et **caractérisé en ce que**
- le filtre numérique (9, 10 ; 9, 11 ; 9°, 10°; 9*, 10*) est un filtre à décimation.

2. Circuit selon la revendication 1, où un modulateur ou conformateur de bruit delta-sigma numérique (10) est disposé entre le filtre numérique (9) et le convertisseur numérique-analogique (8).

3. Circuit selon la revendication 1, où
- un modulateur ou conformateur de bruit delta-sigma numérique (10°) est disposé entre le filtre numérique (9°) et le convertisseur numérique-analogique (8°) dans le chemin de retour (6°), le convertisseur numérique-analogique (8°) étant un convertisseur numérique-analogique à n bits, et
- un modulateur ou conformateur de bruit delta-sigma numérique d'ordre supérieur supplémentaire (10*) est disposé entre un filtre numérique supplémentaire (9*) et un convertisseur numérique-analogique supplémentaire (8*) dans un chemin de retour supplémentaire (6*), le convertisseur numérique-analogique (8*) étant un convertisseur numérique-analogique à m bits.

4. Circuit selon la revendication 3, où
- ces composants dans le premier chemin de retour (6°) sont disposés et/ou commandés pour retourner leur signal analogique traité (ry°) vers un deuxième additionneur (3), le deuxième additionneur (3) étant disposé entre des intégrateurs (2, 4) et étant disposé et/ou programmé pour calculer une différence d'un signal intégré et du signal analogique traité appliqué (ry°), et
- ces composants dans le chemin de retour supplémentaire (6*) sont disposés et/ou commandés pour retourner leur signal analogique traité (ry*) vers un premier additionneur (3), le premier additionneur (3) étant disposé et/ou programmé pour calculer une différence du signal d'entrée (X) et du signal analogique traité appliqué (ry*).

5. Circuit selon une quelconque revendication précédente, comportant dans le chemin de retour (6) un dispositif étant disposé et/ou programmé pour diminuer une cadence d'échantillonnage du signal converti (Y).

6. Circuit selon l'une des revendications précédentes 1 à 5, où le convertisseur numérique-analogique (8) est disposé et/ou programmé comme convertisseur numérique-analogique à 1 bit (8).

7. Procédé de conversion analogique-numérique, où
- un signal d'entrée analogique (X) est traité et quantifié en un signal converti en numérique (Y),
- le signal converti (Y) est traité pour retourner un signal analogique reconverti (ry) destiné à être utilisé pour le calcul d'un signal de différence,
- le signal converti (Y) est filtré numériquement avant d'être reconverti pour obtenir le signal analogique reconverti (ry), et **caractérisé en ce que**
- un filtre à décimation est utilisé pour le filtrage numérique.

8. Procédé selon la revendication 7, où le signal filtré numérique est traité par une modulation de largeur d'impulsions.

9. Procédé selon la revendication 7 ou 8, où le signal filtré numérique est traité par modulation ou conformation de bruit delta-sigma numérique.

10. Procédé selon l'une quelconque des revendications 7 à 9, où le signal converti (Y) est ré-échantillonné pour diminuer sa cadence d'échantillonnage, et converti dans un convertisseur numérique-analogique pour obtenir le signal analogique reconverti (ry).
